# EUROPEAN PATENT SPECIFICATION

(11) **EP 3 419 044 B1**
(45) Date of publication and mention of the grant of the patent: **11.01.2023**
(21) Application number: 18020270.7
(22) Date of filing: 20.06.2018
(51) Int. Cl.: H01J 37/32, H01J 37/34

(54) **PEPVD MACHINE**
PEPVD-MASCHINE
MACHINE PEPVD

(30) Priority: 22.06.2017 EP 17020267
(43) Date of publication of application: 26.12.2018
(73) Proprietor: Bobst Manchester Limited, Heywood, Lancashire OL10 2TL (GB)
(72) Inventor: Copeland, Nicholas John, Stalybridge, Cheshire SK15 2TX (GB)
(74) Representative: Wagner, Sigrid

(56) References cited:
- EP-A1- 3 067 437
- EP-A2- 0 818 801
- WO-A1-2014/088302
- WO-A1-2014/156129
- JP-A- 2011 208 191
- US-A- 3 829 373
- US-A1- 2009 159 429

## Description

The invention relates to a machine for applying a coating on a substrate via a PEPVD process.

A PEPVD process (plasma enhanced physical vapour deposition process) is a particular embodiment of a PVD process, in which a plasma is used.

A group of processes different from PVD processes are CVD processes where a material to be deposited on a substrate is the result from a chemical reaction of at least one precursor supplied with a process gas. CVD processes are often disadvantageous as the process gas is toxic or at least hazardous for the environment. Examples of PEPVD and PECVD apparatus and methods can be found in WO 2014/156129 A1, US 2009/159429 A1, US 3 829 373 A, WO 2014/088302 A1, EP 0 818 801 A2, EP 3 067 437 A1 and JP 2011 208191 A.

The invention relates to providing a layer consisting of a metal and/or a metal oxide, such as aluminium oxide, on a thin film. For example on a plastic foil, which may be used as a packaging material. Such a packaging material may be used for packaging food. The layer may be used to provide a barrier against ingress of gas and/or water and/or light. The layer provided on the foil may be transparent and/or mechanically dense and/or mechanically stable.

The invention provides a machine for applying a coating on a substrate with a PEPVD process according to claim 1.

This machine allows a layer to be deposited on a substrate, which may be mechanically stable, with great uniformity over the width of the substrate. Furthermore, the layer may be deposited at high substrate feed speeds and requiring a low amount of electrical energy. Preferably, the layer is generally resistant to wear caused by handling, which may be caused for example by subsequent conversion steps in forming packaging.

According to a preferred embodiment of the invention the coolant ducts are formed by means of a plurality of ridges, which even more preferably extend helically between the outer and the inner shell.

Preferably, the deposited layer is a barrier layer. Advantageously, embodiments of the invention provide a barrier layer, composed of inorganic oxide such as silicon oxide or aluminium oxide having a high barrier properties that do not significantly decrease when used in fields that require high humidity and/or temperature and/or pressure such as in retort treatments, sterilization treatments or pasteurization treatments used for foods, drugs and the like.

Advantageously, embodiments of the invention provide a transparent barrier layer, such as aluminium oxide. Preferably the barrier layer is optically clear having low optical density and high light transmission characteristics. Transparent packaging is desirable, for example, where customers wish to see a product through its packaging. This is often the case for packaging for food, such as meat of cheese.

Advantageously, embodiments of the invention provide a barrier layer, the optical density of which may be controlled, and which may provide a high mechanical density barrier layer.

A key element of the machine is that in operation a plasma is generated between one or more counter-electrodes and the (process drum) electrode. In this manner, an electric potential difference extends between the one or more counter-electrodes and the drum electrode, causing current to electrically couple "through" the substrate supported by the drum electrode via the operating frequency of the system. It has been found that by using an actively coupled system, current is driven through the substrate to be coated which results in process benefits. This includes higher levels of coating densification through bombardment by plasma ions, amongst others.

Preferably the vacuum source is arranged to maintain in operation a vacuum within the evaporating zone in the order of 10⁻³ mbar to 10⁻⁴ mbar. This level of vacuum ensures that the evaporated material, such as aluminium is not significantly retarded on its way from the evaporator source towards the substrate; thus improving productivity.

Preferably, the evaporating zone comprises one or more gas inlets arranged to input controlled quantities of gas or gases, hereafter "plasma gases", in the vicinity of the site of the plasma formation. Preferably, such gas comprises argon, nitrogen, oxygen or helium or a combination or any two, any three or all of these gases. Advantageously, this locally reduces the vacuum level to a controlled extent, that is to say within the plasma cloud. This in turn augments the electrical conductivity of the cloud of the evaporated material. Thus, counterintuitively plasma may be more readily maintained even at relatively high global vacuum levels, such as 10⁻⁴ mbar. The atoms of the inlet gas contribute to a high-quality coating on the substrate by bombarding and compacting the layer of deposited material. Preferably, heavy gas ions such as argon are used for this purpose. Plasma stability may be enhanced through the inclusion of helium.

In certain preferred embodiments, the evaporating zone further comprises one or more further gas inlets arranged to input controlled quantities of one or more reactive gases, such as oxygen or nitrogen or other reactive gas, hereafter "reactive gases". The reactive gas or gases are preferably input in the vicinity of the substrate and the drum electrode. By introducing such gases close to the substrate and the drum electrode, and thus distant from the point that the evaporated material is evaporated, oxygenation of the evaporated material throughout much of the plasma cloud is reduced, or eliminated. This advantageously has the effect of maintaining the electrical conductivity of the plasma cloud.

In one embodiment, the reactive gas is oxygen so that by having the oxygen react with the coating source material, such as aluminium, a coating with a metal oxide, such as aluminium oxide, can be obtained.

Advantageously, in such a reactive mode of operation, the use of an energetic plasma allows a higher degree of mixing between a process gas, such as oxygen, and the evaporated material, such as aluminium. In the case of aluminium and process oxygen, for example, this means that the oxygen is more chemically bound to the aluminium.

Whilst Al₂O₃ is transparent, AlOₓ appears increasingly grey as the chemically bound oxygen value, x, is decreases below 3/2. Thus, by increasing the degree to which the oxygen present in the barrier layer is bound to the aluminium, the transparency of the layer may be increased for a total given oxygen content. Expressed differently, the oxygen used in the reactive process is used more efficiently due to the presence of the plasma. In embodiments of the invention this may typically give rise to a 15-25% reduction in the amount of oxygen required. Thus, more transparent coatings can be produced whilst still maintaining satisfactory barrier properties. A transparent barrier layer on the substrate is particularly advantageous in the field of the packaging industry.

Generally speaking, three different categories of embodiments of the invention are possible, depending on the different combinations of: (i) the of evaporated materials used, (ii) the plasma gases used, and (iii) whether or not a reactive gas is used. The following combinations are particularly advantageous:
Where a metal such as aluminium is used as the coating material and no process gas is introduced, then the result is a process which is not reactive. In such a process a purge gas may optionally be employed in the region of the counter electrodes. Gases may include oxygen or argon, for example.

In an alternative in which again metal such as aluminium is being used as the coating material and oxygen or argon is used as the purge gas, a reactive process gas such as oxygen is introduced into the evaporation zone, making it a reactive process. The coating can in particular be an aluminium oxide coating.

In a third variant, a metal oxide such as silicon-monoxide (SiO) is made available in the evaporation zone. The electrodes are purged with oxygen or argon while some or no process gas is used depending on stoichiometric requirements.

In all variants, the metal coating material can be evaporated by resistively heating it.

Different embodiments of the invention may use different metal or metal oxide coating source materials including, for example: aluminium, aluminium oxide, copper, silicon-monoxide, titanium, or zinc sulphide. Thus, a wide variety of coatings can be obtained.

Embodiments of the invention include one or more counter-electrodes, which are arranged in operation to maintain a plasma in contact with the surface of the substrate passing through the evaporating zone.

Advantageously, the number and location of the counter-electrodes can be selected in a flexible manner to provide the required coating properties for a given machine geometry and the process employed.

In some embodiments the counter-electrodes are arranged to maintain a plasma in contact with the surface of the substrate in a first zone in which the plasma treats the substrate. In other embodiments the counter-electrodes are arranged to maintain a plasma in contact with the surface of the substrate in a second zone in which there is already a deposited layer on the substrate. In yet other embodiments the counter-electrodes are arranged to maintain a plasma in contact with the surface of the substrate in both the first and the second zones.

The placement of the counter-electrodes at the upstream or inlet side of the evaporation zone will cause plasma to treat the substrate as it enters the evaporation zone either before deposition occurs or before the deposited layer has built up to a significant thickness, providing a seeding layer. In this manner the functional charges of the surface of the substrate can be altered and the surface area of the substrate can be increased through micro-etching. This provides a more uniform substrate surface promoting the uniformity of the deposited layer. It also promotes improved adhesion of the deposited layer to the substrate. This in turn promotes improved film characteristics in later conversion steps or in relation to exposure to and usage of the film for example in later processing steps such as retort treatments, sterilization treatments or pasteurization treatments.

The placement of counter-electrodes at the downstream or outlet side of the evaporation zone will cause plasma to treat the deposited layer as it leaves the evaporation zone. In this manner the densification of the layer may be increased through the bombardment of heavy ions such as argon. In turn this results in less fracture sites and consequently improved resistance to handing of the film.

In all the embodiments the function of the counter-electrodes is provided by gas-purge electrodes, or GPEs. GPEs provide the counter-electrode functionality and at the same time allow controlled amounts of selected gas to be introduced into the evaporation zone. Advantageously, GPEs may be employed at both the inlet and the outlet side of the evaporation zone simultaneously.

Magnets are provided within the drum electrode. The magnets allow the distribution of the plasma formed between the counter-electrodes and the drum electrode to be influenced by containing it and focusing it adjacent the substrate. This arrangement reduces the electrical impedance of the system. In turn this causes the electrical current to be increased and consequently the mechanical density of the deposited film to be increased. By appropriately directing and containing the plasma, the level of uniformity of the deposited aluminium oxide is increased and/or the effectiveness of the plasma treatment of the substrate may be optimised.

Preferably, the magnets are displaceably arranged within the drum. The position of the magnet field outside the drum can be conveniently influenced by the distance at which the magnets are arranged from the outer shell of the drum.

According to the embodiments, the process drum is chilled. This avoids excessive temperatures on the surface of the process drum, which could negatively affect the substrate.

A cooling fluid/cooling liquid is guided between an outer and an inner shell of the process drum. Confining the path for the cooling fluid to an angular space having an inner radius almost as large as the outer radius of the process drum ensures that a large inner space is available within the drum for positioning the magnets. In particular, the magnets can be positioned close to the outer surface of the process drum.

According to an embodiment of the invention, the cooling fluid is supplied and discharged at one and the same end of the process drum. As a consequence, the opposite end of the process drum is available for housing the mechanism for displacing the magnets within the drum.

Preferably, the substrate is fed to the evaporating zone from an unwinding unit and fed from the evaporating zone to a rewinding unit. Preferably, the unwinding unit and rewinding unit are arranged in a winding zone, the winding zone being connected to a vacuum source. The vacuum source is preferably adapted for creating within the winding zone a pressure in the order of 10⁻² mbar. It is thus not necessary to establish the high-level vacuum in the entire machine. Rather, the high-level vacuum is confined to the evaporation zone where the metal or oxide is deposited on the substrate while a low-level vacuum is established in other portions of the machine.

Preferably, a sealing arrangement is provided for sealing at the areas where the substrate is guided from the winding zone into the evaporation zone and back to the winding zone. The sealing arrangement can for example be a very narrow gap, long in the direction of fluid flow known as a "conductance" gap or seal, through which the substrate is guided, thereby preventing the atmosphere from the winding zone from being quickly transferred into the evaporation zone.

The power supply supplies an AC voltage with a medium frequency in the order of 5-200 kHz for creating the desired plasma within the evaporation zone.

The power of the power supply can be in the order of 1-10 kW, thereby being significantly lower (by a factor of approximately 10 to 30) than the power necessary for prior art processes.

As a substrate, the following materials are preferably used: PET, OPP, BOPP, CPP, PE, BOPA or PVC.

The machine according to the invention can preferably be operated such that the substrate is advanced at a speed of more than 300 m/min, preferably at a speed of more than 400 m/min and most preferably at a speed of more than 1,000 m/min. Thus, a very high output is achieved.

The invention will now be described with reference to an embodiment which is shown in the enclosed drawings. In the drawings,
- Figure 1 schematically shows a machine according to a first embodiment of the invention,
- Figure 2 shows in a perspective, cut view the process drum used in the machine of Figure 1,
- Figure 3 shows in a perspective view the process drum of Figure 2 with an outer shell removed,
- Figure 4 shows the process drum of Figure 3 with the outer and the inner shells being shown in a transparent manner,
- Figure 5 shows a cross section through the drum of Figure 2
- Figure 6 shows in an enlarged perspective and cut view of one of the axial ends of the drum of Figure 2,
- Figure 7 shows in an enlarged perspective and cut view the other end of the drum of Figure 2,
- Figure 8 schematically shows a machine according to a second embodiment of the invention, and
- Figure 9 schematically shows a machine according to a third embodiment of the invention.

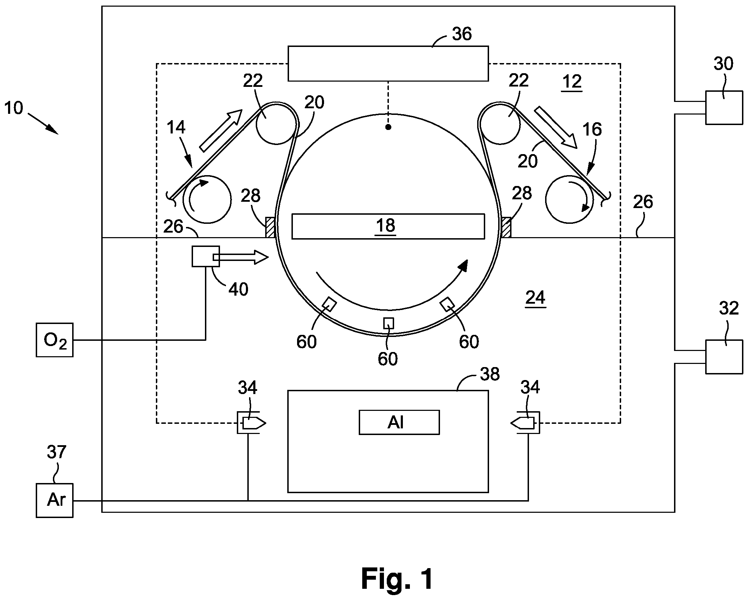

Figure 1 schematically shows the main components of a machine 10 for applying a coating to a substrate via a PEPVD method.

The machine 10 has a winding zone 12 in which a substrate unwinding unit 14 and a substrate rewinding unit 16 are arranged.

Substrate unwinding unit 14 can very generally be considered as a reel which comprises a supply of a substrate to be coated. The substrate is in particular a plastic foil from one of the following materials: PET, OPP, BOPP, CPP, PE, BOPA or PVC. The substrate rewinding unit 16 can generally be considered as a reel for winding the substrate after the desired coating has been applied to it.

Further, a process drum electrode 18 is provided which is rotatably mounted in machine 10. Process drum 18 is non-ferrous (for example stainless steel) and electrically conductive at least on its outer circumference.

The width of process drum 18 is at least equal to the width of a substrate 20 provided by substrate unwinding unit 14 and wound on substrate rewinding unit 16.

In this embodiment of the invention a web transport system is provided that includes a substrate unwinding unit 14 together with guiding rollers 22, process drum 18 and substrate rewinding unit 16 defines a substrate path, or a web transport path, along which the substrate 20 can be unwound from substrate unwinding unit 14, guided so as to loop around a significant portion of the outer circumference of process drum 18 and finally be wound on substrate rewinding unit 16. In the embodiment shown, substrate 20 winds around process drum 18 for slightly more than 180°. During operation, the surface speed of process drum 18 is the same as the speed at which substrate 20 is advanced.

Substrate unwinding unit 14, guiding rollers 22 and substrate rewinding unit 16 are arranged in winding zone 12 whereas the substrate is guided by means of process drum 18 through an evaporation zone 24. The separation between winding zone 12 and evaporation zone 24 is here schematically depicted with reference numeral 26.

In the embodiment shown, substrate 20 is exposed to evaporation zone 24 over an angle of slightly less than 180° along the perimeter of process drum 18; this region being known as the "aperture".

A schematically shown sealing arrangement 28 is provided close to process drum 18 at the separation 26 for sealing between winding zone 12 and evaporation zone 24. The sealing arrangement 28 can be implemented in the form of a very narrow, or conductance, gap through which substrate 20 passes when being advanced from winding zone 12 into evaporation zone 24 and back into winding zone 12.

A vacuum source 30 is connected to winding zone 12 for establishing a vacuum therein. The pressure in the winding zone is in the order of 10⁻² mbar.

A vacuum source 32 is connected to evaporation zone 24. Vacuum source 32 is adapted for establishing a process pressure in the order of 10⁻⁴ mbar in evaporation zone 24.

Within evaporation zone 24, a plurality of counter-electrodes 34 are arranged. Counter-electrodes 34 are connected to a power supply 36. Power supply 36 is also electrically connected to process drum electrode 18.

In this embodiment, the counter-electrodes 34 are arranged opposite each other on different sides of a median plane extending through process drum 18. Even though only one electrode 34 is visible in Figure 1 at each side of the median plane, a plurality of electrodes 34 may be arranged in practice at suitable distances from each other along lines which extend in parallel with the axis of rotation of process drum 18.

By capacitively coupling electric power with a frequency of for example 40 kHz between process drum electrode 18 and counter-electrodes 34, a process plasma can be generated between the counter-electrodes and the process drum electrode (more precisely between the counter-electrodes 34 and substrate 20 guided along process drum electrode 18).

The electric power of power supply 36 can be in the order of 2 kW. The counter-electrodes 34 are gas-purged, adapted to inject controlled amounts of selected gas or gases into the evaporation zone 24; in this embodiment, argon. A schematically depicted argon source 37 provides a flow of argon into evaporation zone 24.

As an aluminium oxide barrier layer is to be deposited on substrate 20, a PVD aluminium source 38 is arranged within evaporation zone 24. The aluminium source 38 is preferably in the form of a resistively heated evaporator boat, although inductive heating could instead be used.

Within evaporation zone 24, an oxygen supply 40 is arranged which provides a flow of oxygen in the vicinity of substrate 20 and drum electrode 18. In particular, oxygen supply 40 is arranged such that the oxygen is made available in evaporation zone 24 adjacent or proximate to an upstream location of substrate 20. While this configuration works well for aluminium oxide, different locations for the oxygen supply 40 within the evaporation zone might be chosen.

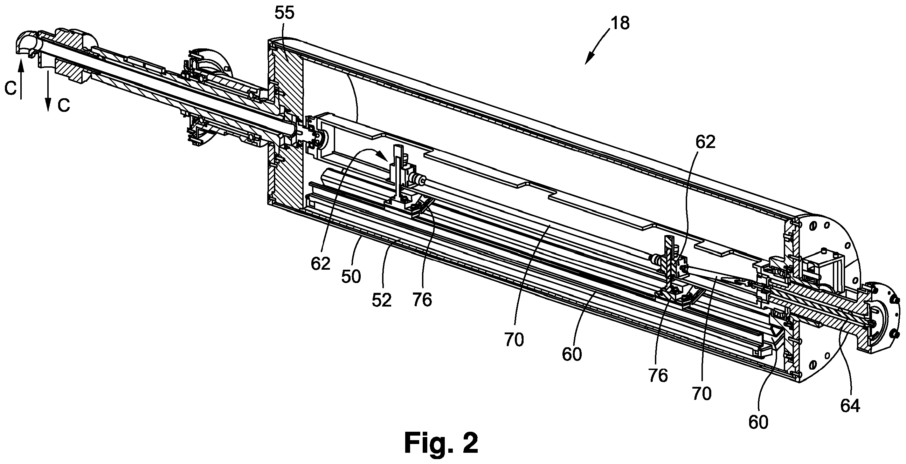

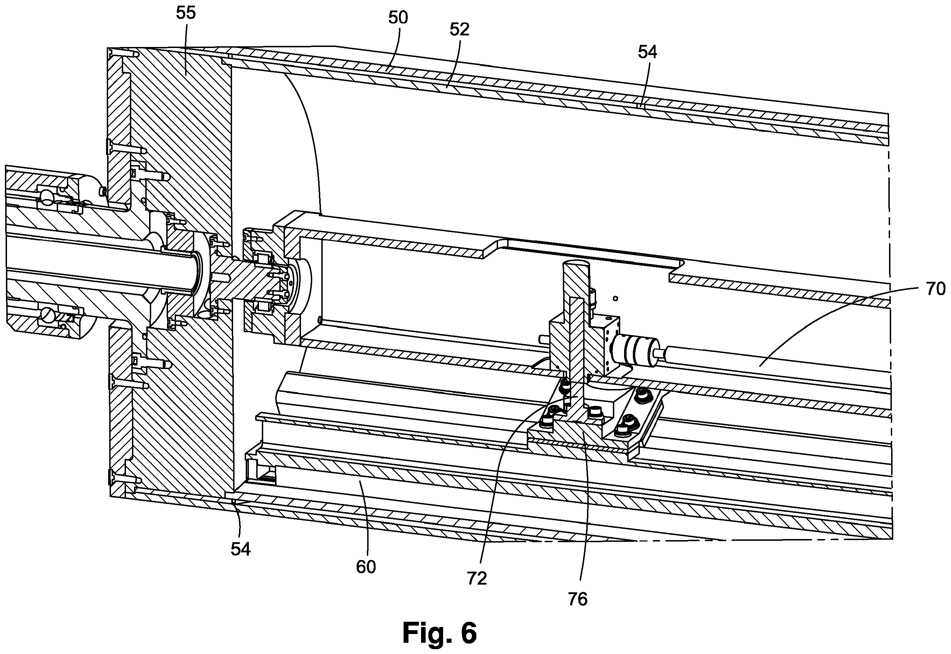

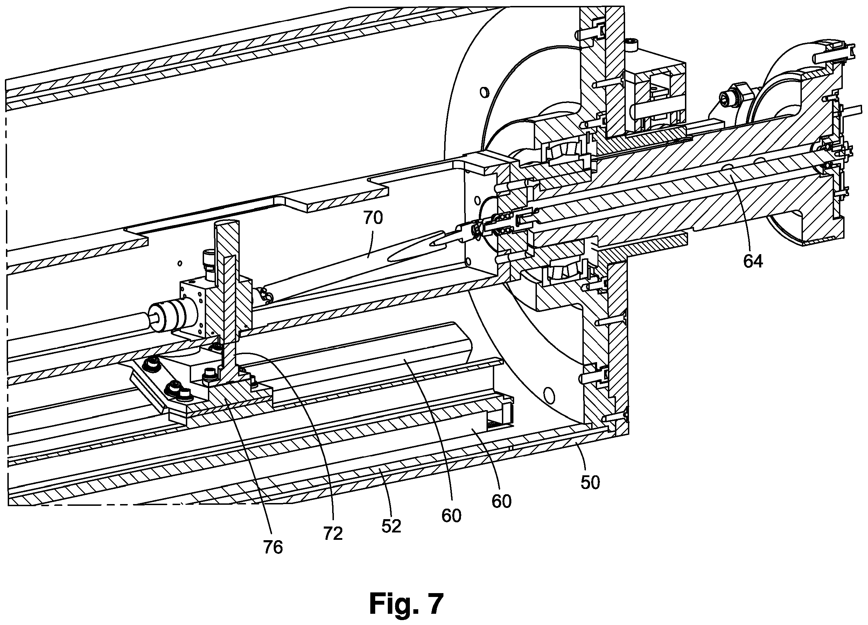

Process drum electrode 18 comprises an outer shell 50 (see Figures 2 to 7) and an inner shell 52. Between shells 50, 52, a coolant is guided for controlling the temperature of the outer surface of process drum 18. In particular, a coolant flow is guided through coolant ducts 53 embedded between outer and inner shells 50, 52.

As can be seen in Figure 2, coolant C is supplied to process drum 18 and discharged therefrom at one and the same side (the left side with respect to Figure 2). Thus, the "out" and "return" paths of the coolant ducts between outer and inner shells 50, 52 extend in an alternating manner over the entire width of process drum 18.

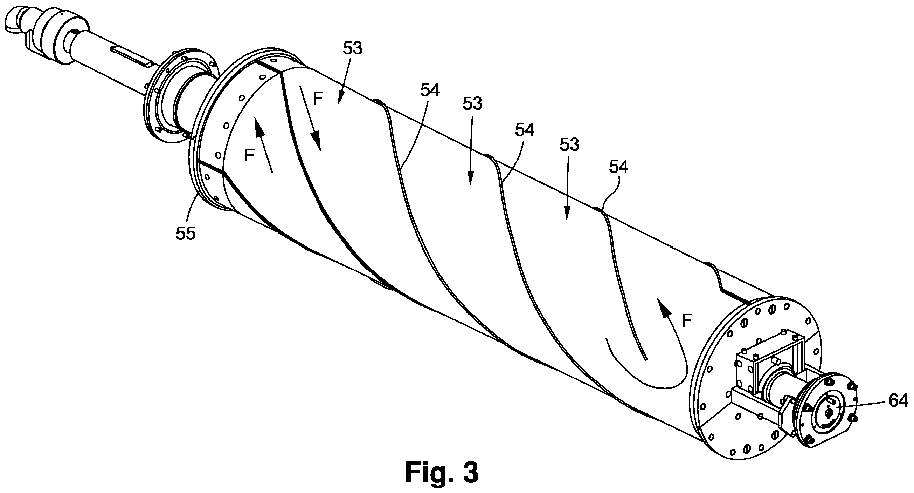

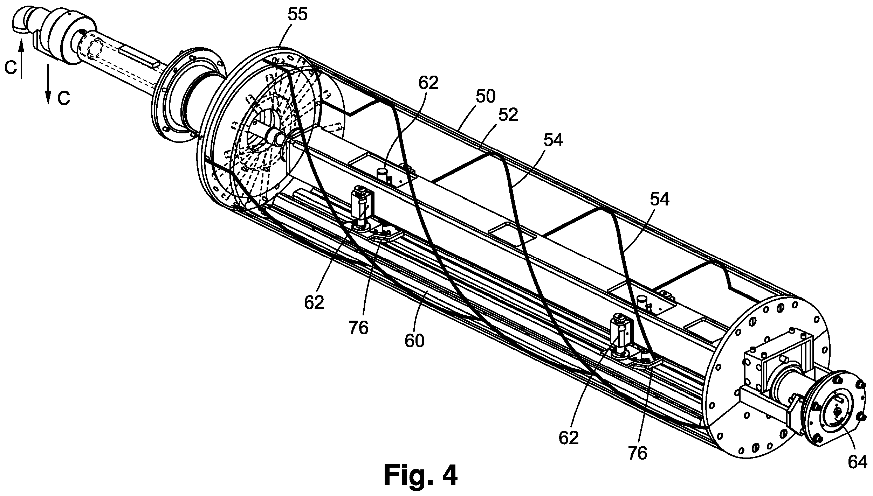

The coolant ducts 53 are formed by means of a plurality of ridges 54 which extend helically between the outer and the inner shells 50, 52 (please see in particular Figures 3 and 4).

The ridges 54 delimit flow channels (indicated by arrows F) which extend from the left flange 55 (referred to as supply flange) at which coolant C is supplied, in a helical manner towards to opposite axial end of the drum and then back to the supply flange 55. This is the result of every other ridge 54 ending in a short distance from the flange which is opposite the supply flange 55 so that adjacent flow channels are formed through which the coolant flows in opposite directions.

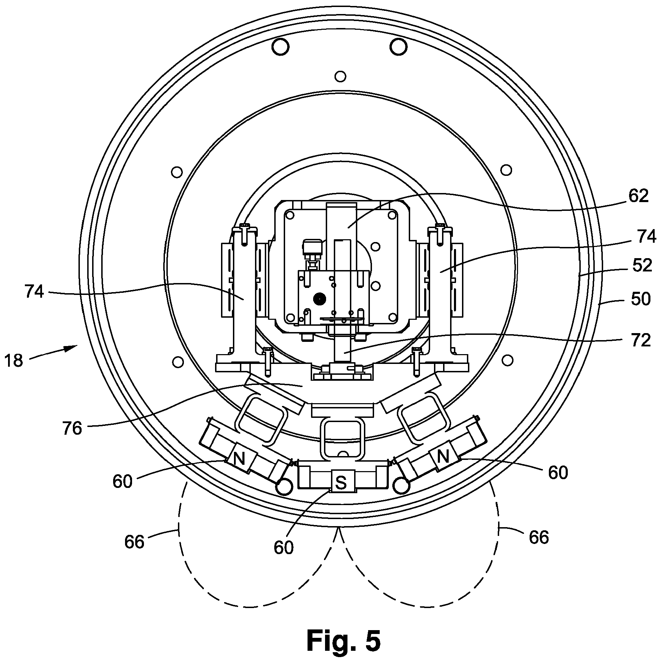

As can be further seen from Figures 2 to 8, a plurality of magnets 60 is arranged in the interior of process drum 18 electrode. The magnets 60 are arranged with alternating polarity as shown in Figure 5).

Magnets 60 extend over (almost) the entire width of process drum electrode 18 and are mounted so as to be stationary within process drum electrode 18 as the process drum electrode 18 turns. As can be seen in Figure 1, magnets 60 are arranged such that they are positioned in the side of process drum electrode 18 adjacent the aluminium evaporator 38.

The distance between magnets 60 and the inner surface of inner shell 52 can be adjusted by means of a schematically depicted adjustment device 62. Adjustment device 62 is actuated via a transmission 64, which may be powered or manual, arranged at the axial end of process drum 18 opposite the end where the coolant is supplied and discharged.

By adjusting the distance between the inner surface of inner shell 52 and magnets 60, the magnetic field (schematically depicted with reference numeral 66 in Figure 5) can be adjusted relative to outer surface of the drum. The plasma is more intense in the confines of the magnetic field. The magnetic field thus focuses or contains and directs the plasma in the optimum position relative to the surface of the substrate. The optimal position is that in which the functional performance of the film is optimised by the plasma. This may be determined with experience, or trial and error.

Generally speaking, it is desirable that the magnets are arranged to focus plasma over as large an aperture as possible. In this manner the "dwell" during which deposition can occur is maximized and the throughput of the machine is thus increased. It will be understood therefore that the diameter of the process drum electrode 18 and the aperture go hand in hand. Because of process drum electrode 18 having a diameter which is large compared to prior art machines, it achieves may yield a significantly higher throughput.

The adjustment device 62 comprises a rotatable shaft 70 with which it is actuated from outside process drum 18. The rotation of shaft 70 can be transformed into a translational movement by means of a rack and pinion drive or other suitable mechanism, generating a translational movement of a central holding rod 72.

On either side of holding rod 72, guiding rods 74 are arranged which precisely guide a carrier structure 76 at which holding rod 72 engages and to which the magnets 60 are attached.

For creating a barrier layer as a coating on substrate 20, aluminium atoms are thermally released by aluminium evaporator 38 into evaporation zone 24. At the same time, argon is discharged into the evaporation zone 24 by gas purged electrodes 34 and a plasma is created within evaporation zone 24 by applying a suitable electrical potential difference between process drum electrode 18 and counter-electrodes 34. Further, oxygen is supplied to evaporation zone 24 at the side where substrate 20 enters into evaporation zone 24.

The plasma activates the substrate so as to increase the bonding between the substrate and the coating. Further, it increases the reactivity and mixing between the aluminium atoms and the oxygen molecules. The aluminium oxide formed within evaporation zone 24 is deposited on the surface of substrate 20 such that a uniform, compact barrier layer is formed. The charged argon ions present in evaporation zone 24 assist in compacting the deposited layer without chemically interacting.

As electrodes 34 are purged with the argon, no aluminium is deposited on the electrodes. Thus, the "disappearing anode problem" is reliably avoided.

By suitably setting the distance at which magnets 30 are arranged from the inner surface of inner shell 52 of process drum 18, the plasma can be influenced such that a uniform coating is achieved on the surface of substrate 20. The substrate can be moved at very high speeds through evaporation zone 24. Speeds in excess of 300 m/min, sometimes in excess of 1,000 m/min, are possible.

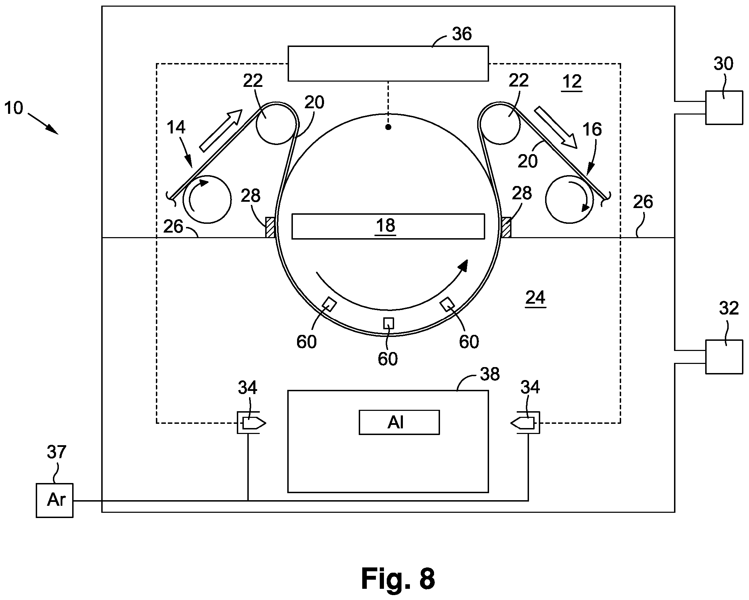

In Figure 8, a machine according to a second embodiment is shown. It largely corresponds to the first embodiment, and the same reference numerals are used for components known from the first embodiment. Thus, construction and operation of the machine according to the second embodiment corresponds to the first embodiment unless differences are explained in the following.

In the second embodiment, no reactive gas is used. Thus, supply 40 for the reactive gas is eliminated, giving rise to a non-reactive process.

Supply 37 for the gas input by the gas-purged electrodes 34 supply oxygen, argon, or helium supply.

The metal coating source 38 can be aluminium. It is resistively heated, although again it could be heated by induction, so as to make available aluminium atoms in the evaporation zone, which are finally deposited on the substrate.

Even though Figure 8 indicates that the material of the metal coating source 38 is aluminium, it is to be kept in mind that other materials can be used as well

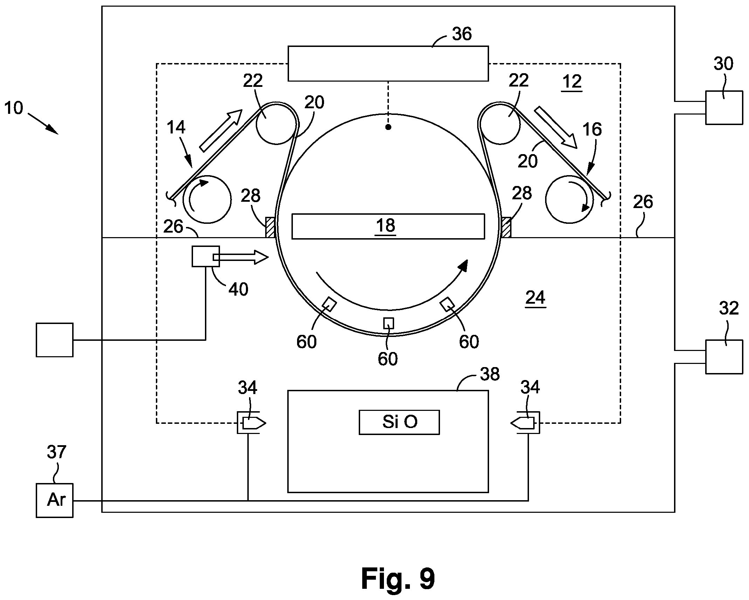

In Figure 9, a machine according to a third embodiment is shown. It largely corresponds to the first embodiment, and the same reference numerals are used for components known from the first embodiment. Thus, construction and operation of the machine according to the third embodiment corresponds to the first embodiment unless differences are explained in the following.

In the third embodiment, the metal coating source is a metal oxide which is resistively heated. As an example, SiO is shown here. It however is to be kept in mind that other materials are suitable as well.

Via the gas purged electrodes 34, oxygen or argon is input, and some or no plasma gas is used depending on stoichiometric requirements.

## Claims

1. A machine (10) for applying a coating on a substrate (20) with a PEPVD process, the machine (10) comprising:
an evaporating zone (24) connected to a vacuum source (32) for maintaining a vacuum within the evaporating zone (24), and comprising a metal or metal oxide coating source (38) and one or more counter-electrodes (34),
a rotatable process drum electrode (18) comprising magnets (60) arranged within its outer circumference, the drum electrode (18) forming part of a substrate path and arranged to guide the substrate (20) through the evaporating zone,
wherein the process drum electrode comprises an outer shell and an inner shell and wherein coolant ducts are embedded between the outer shell and the inner shell, and
an alternating current power supply (36) for generating an electrical potential difference between the counter electrodes (34) and the drum electrode (18),
in operation the machine being arranged to generate a plasma between one or more counter-electrodes (34) and the drum electrode (18), the magnets (60) being adapted to direct and contain the plasma adjacent the substrate in the evaporating zone, the machine being further arranged such that current from the power supply (36) couples between the counter electrodes (34) and the drum electrode (18), through the substrate (20),
**characterized in that** one or more of the counter-electrodes is a gas purged electrodes (34) and comprising a plurality of gas purged counter-electrodes (34) in the form of a bar or a plurality of bars.

2. The machine of claim 1, wherein the coolant ducts are formed by means of a plurality of ridges which preferably extend helically between the outer and the inner shell.

3. The machine of claim 1 or claim 2 arranged to evaporate the metal or metal oxide coating source using resistive or induction heating.

4. The machine of any preceding claim wherein in operation the vacuum in the evaporating zone is of the order of 10⁻⁴ mbar.

5. The machine of any preceding claim wherein the evaporating zone comprises one or more gas inlets arranged to inject into the evaporating zone one or more plasma gases.

6. The machine of claim 5 wherein the plasma gases include one or more of argon or oxygen or helium.

7. The machine according to any preceding claim comprising apparatus arranged to introduce a reactive gas in the evaporating zone (24) in the vicinity of the process drum electrode (18).

8. The machine according to claim 7, wherein the process gas is a reactive gas such as oxygen, arranged to react with the coating source material.

9. The machine according to any preceding claim, wherein the metal or metal oxide coating source (38) is any one of: aluminium, aluminium oxide, copper, silicon-monoxide, titanium, or zinc sulphide.

10. The machine of any preceding claim, wherein magnets (60) are arranged within the process drum (18).

11. The machine of claim 10, wherein the magnets (60) are displaceably arranged within the process drum (18).

12. The machine of any preceding claim wherein the process drum (18) is chilled.

13. The machine of claim 12, wherein a cooling fluid (C) is guided between an outer and an inner shell (50, 52) of the process drum (18).

## Patentansprüche

1. Maschine (10) zum Aufbringen einer Beschichtung auf einem Substrat (20) innerhalb eines PEPVD-Prozesses, wobei die Maschine (10) umfasst:
eine Verdampfungszone (24), welche mit einer Vakuumquelle (32) verbunden ist, um ein Vakuum innerhalb der Verdampfungszone (24) aufrechtzuerhalten, und eine Metall- oder Metalloxidbeschichtungsquelle (38) und eine oder mehrere Gegenelektroden (34) umfasst,
eine drehbare Prozesstrommelelektrode (18), welche Magnete (60) umfasst, welche innerhalb ihres äußeren Umfangs angeordnet sind, wobei die Trommelelektrode (18) Teil eines Substratwegs und angeordnet ist, um das Substrat (20) durch die Verdampfungszone zu führen,
wobei die Prozesstrommelelektrode eine äußere Hülle und eine innere Hülle umfasst, und wobei Kühlmittelkanäle zwischen der äußeren Hülle und der inneren Hülle integriert sind, und
eine Wechselstromquelle (36) zum Erzeugen einer elektrischen Potenzialdifferenz zwischen den Gegenelektroden (34) und der Trommelelektrode (18),
wobei die Maschine im Betrieb angeordnet ist, um zwischen einer oder mehrerer Gegenelektroden (34) und der Trommelelektrode (18) ein Plasma zu erzeugen, wobei die Magnete (60) adaptiert sind, um das zu dem Substrat benachbarte Plasma zu führen und in der Verdampfungszone zu halten, wobei die Maschine weiter so angeordnet ist, dass Strom von der Stromquelle (36) zwischen den Gegenelektroden (34) und der Trommelelektrode (18) durch das Substrat (20) koppelt,
**dadurch gekennzeichnet, dass** eine oder mehrere der Gegenelektroden eine gasgespülte Elektrode (34) ist und eine Vielzahl von gasgespülten Gegenelektroden (34) in der Form eines Balkens oder einer Vielzahl von Balken umfasst.

2. Maschine nach Anspruch 1, wobei die Kühlmittelkanäle mittels einer Vielzahl von Rippen gebildet sind, welche sich bevorzugt schraubenförmig zwischen der äußeren und der inneren Hülle erstrecken.

3. Maschine nach Anspruch 1 oder Anspruch 2, welche angeordnet ist, um die Metall- oder Metalloxidbeschichtungsquelle unter Verwendung von Widerstands- oder Induktionsheizung zu verdampfen.

4. Maschine nach einem der vorstehenden Ansprüche wobei im Betrieb das Vakuum in der Verdampfungszone eines in der Größenordnung von 10⁻⁴ mbar ist.

5. Maschine nach einem der vorstehenden Ansprüche, wobei die Verdampfungszone einen oder mehrere Gaseinlässe umfasst, welche angeordnet sind, um ein oder mehrere Plasmagase in die Verdampfungszone einzuspritzen.

6. Maschine nach Anspruch 5, wobei die Plasmagase eines oder mehrere von Argon oder Sauerstoff oder Helium beinhalten.

7. Maschine nach einem der vorstehenden Ansprüche, welche Einrichtung umfasst, welche angeordnet ist, um ein Reaktionsgas in die Verdampfungszone (24) in der Nähe der Prozesstrommelelektrode (18) einzuführen.

8. Maschine nach Anspruch 7, wobei das Prozessgas ein Reaktionsgas wie beispielsweise Sauerstoff ist, welches angeordnet ist, um mit dem Beschichtungsgrundmaterial zu reagieren

9. Maschine nach einem der vorstehenden Ansprüche, wobei die Metall- oder Metalloxidbeschichtungsquelle (38) eine beliebige der folgenden ist: Aluminium, Aluminiumoxid, Kupfer, Siliziummonoxid, Titan oder Zinksulfid.

10. Maschine nach einem der vorstehenden Ansprüche, wobei Magnete (60) innerhalb der Prozesstrommel (18) angeordnet sind.

11. Maschine nach Anspruch 10, wobei die Magnete (60) innerhalb der Prozesstrommel (18) verschiebbar angeordnet sind.

12. Maschine nach einem der vorstehenden Ansprüche, wobei die Prozesstrommel (18) gekühlt ist.

13. Maschine nach Anspruch 12, wobei zwischen einer äußeren und einer inneren Hülle (50, 52) der Prozesstrommel (18) eine Kühlflüssigkeit (C) geführt ist.

## Revendications

1. Machine (10) pour appliquer un revêtement sur un substrat (20) avec un processus PEPVD, la machine (10) comprenant :
une zone d'évaporation (24) raccordée à une source de vide (32) pour maintenir un vide dans la zone d'évaporation (24), et comprenant une source de revêtement de métal ou d'oxyde de métal (38) et une ou plusieurs contre-électrodes (34),
une électrode à tambour à processus rotative (18) comprenant des aimants (60) agencés dans sa circonférence extérieure, l'électrode à tambour (18) formant une partie d'un trajet de substrat et agencée pour guider le substrat (20) à travers la zone d'évaporation,
dans laquelle l'électrode à tambour à processus comprend une enveloppe extérieure et une enveloppe intérieure et dans laquelle des conduits de liquide de refroidissement sont intégrés entre l'enveloppe extérieure et l'enveloppe intérieure, et
une alimentation électrique en courant alternatif (36) pour générer une différence de potentiel électrique entre les contre-électrodes (34) et l'électrode à tambour (18),
en fonctionnement, la machine étant agencée pour générer un plasma entre une ou plusieurs contre-électrodes (34) et l'électrode à tambour (18), les aimants (60) étant adaptés pour diriger et contenir le plasma adjacent au substrat dans la zone d'évaporation, la machine étant en outre agencée de sorte que du courant provenant de l'alimentation électrique (36) se couple entre les contre-électrodes (34) et l'électrode à tambour (18), à travers le substrat (20),
**caractérisée en ce qu'**une ou plusieurs des contre-électrodes sont des électrodes purgées au gaz (34) et comprenant une pluralité de contre-électrodes purgées au gaz (34) sous la forme d'une barre ou d'une pluralité de barres.

2. Machine selon la revendication 1, dans laquelle les conduits de liquide de refroidissement sont formés au moyen d'une pluralité d'arêtes qui s'étendent de préférence hélicoïdalement entre l'enveloppe extérieure et l'enveloppe intérieure.

3. Machine selon la revendication 1 ou la revendication 2 agencée pour faire évaporer la source de revêtement de métal ou d'oxyde de métal en utilisant un chauffage résistif ou par induction.

4. Machine selon une quelconque revendication précédente, dans laquelle, en fonctionnement, le vide dans la zone d'évaporation est de l'ordre de 10⁻⁴ mbar.

5. Machine selon une quelconque revendication précédente, dans laquelle la zone d'évaporation comprend une ou plusieurs entrées de gaz agencées pour injecter un ou plusieurs gaz plasma dans la zone d'évaporation.

6. Machine selon la revendication 5, dans laquelle les gaz plasma incluent un ou plusieurs parmi l'argon ou l'oxygène ou l'hélium.

7. Machine selon une quelconque revendication précédente, comprenant un appareil agencé pour introduire un gaz réactif dans la zone d'évaporation (24) à proximité de l'électrode à tambour à processus (18).

8. Machine selon la revendication 7, dans laquelle le gaz de processus est un gaz réactif tel que l'oxygène, agencé pour réagir avec le matériau de source de revêtement.

9. Machine selon une quelconque revendication précédente, dans laquelle la source de revêtement de métal ou d'oxyde de métal (38) est l'un quelconque parmi : l'aluminium, l'oxyde d'aluminium, le cuivre, le monoxyde de silicium, le titane, ou le sulfure de zinc.

10. Machine selon une quelconque revendication précédente, dans laquelle des aimants (60) sont agencés dans le tambour à processus (18).

11. Machine selon la revendication 10, dans laquelle les aimants (60) sont agencés de manière déplaçable dans le tambour à processus (18).

12. Machine selon une quelconque revendication précédente, dans laquelle le tambour à processus (18) est réfrigéré.

13. Machine selon la revendication 12, dans laquelle un fluide de refroidissement (C) est guidé entre une enveloppe extérieure et une enveloppe intérieure (50, 52) du tambour à processus (18).
